# EUROPEAN PATENT APPLICATION

(11) **EP 4 836 632 A1**
(43) Date of publication of application: **04.11.2026**
(21) Application number: 26175667.0
(22) Date of filing: 30.04.2026
(51) Int. Cl.: H10D 84/03, H03K 19/00, H10D 30/01, H10D 84/01, H10D 84/87

(54) **MULTI-VT CMOS DEVICES AND METHODS**

(30) Priority: 02.05.2025 US 202563798956 P; 16.04.2026 US 202619649479
(71) Applicant: Samsung Electronics Co., Ltd., Suwon-si, Gyeonggi-do 16677 (KR)
(72) Inventor: ARKALI RADHAKRISHNA, Nischal, San Jose, CA 95134 (US); JAIN, Saurabh, San Jose, CA 95134 (US); CEYHAN, Ahmet, San Jose, CA 95134 (US); KIM, Minkyu, San Jose, CA 95134 (US)
(74) Representative: Kuhnen & Wacker Patent- und Rechtsanwaltsbüro PartG mbB

(57) **Abstract**

A multi-threshold voltage, VT, complementary metal-oxide-semiconductor, MTCMOS, device is configured to be part of a digital circuit. The MTCMOS device (100) includes at least one pair of transistors. A first transistor (130) in the pair of transistors includes a first polarity and a first VT flavor. A second transistor (140) in the pair of transistors includes a second polarity and a second VT flavor. The second VT flavor is distinct from the first VT flavor.

## Description

### TECHNICAL FIELD

The disclosure generally relates to semiconductor technology. More particularly, the subject matter disclosed herein relates to improvements to complementary metal-oxide-semiconductor (CMOS) devices and methods.

### SUMMARY

Multi-threshold voltage (VT) CMOS (MTCMOS) technology may be utilized to optimize delay, area, and/or power in digital circuits. MTCMOS technology may be utilized to achieve chip frequency targets using low-VT cells on critical paths. MTCMOS technology may be utilized to recover power by swapping non-critical path circuits with high-VT transistors. MTCMOS technology may be utilized to reduce area by swapping high-VT high drive circuits with low-VT low drive circuits to reduce circuit footprint. However, adding more VT flavors in a process technology may require additional cost and/or process complexity. In addition, using low-VT cells on critical paths may result in high leakage power. In the present patent application VT flavor may refer to a transistor type defined by a target threshold voltage range, wherein different VT flavors correspond to nonoverlapping threshold voltage ranges set by semiconductor process parameters.

Adding multiple channel lengths for leakage granularity may require additional cost and/or process complexity. Adding multiple channel lengths for leakage granularity may lead to higher channel capacitance which may increase power consumption.

In gate-all-around (GAA) architecture, smaller nanosheets may have higher VT. Short-channel effect and/or quantum effects for GAA architecture may make rise/fall characteristics harder to control, especially at low voltages.

Disclosed devices and methods may provide more leakage/frequency granularity. Disclosed devices and methods may be configured to improve frequency at matched leakage which may improve performance. Disclosed devices and methods may reduce leakage at matched frequency. Disclosed devices and methods may be configured to compensate for a transistor strength mismatch due to local layout effect (LLE). Disclosed devices and methods may be configured to compensate for a VT shift from LLE. Disclosed devices and methods may be configured to compensate for a VT increase due to use of a narrower nanosheet with a lower VT flavor. Disclosed devices and methods may be configured to improve power, performance, and area (PPA).

In disclosed devices and methods, mixed-VT may be used in a multi-height standard cell to adjust for LLE effects, add more leakage/frequency granularity, and/or compensate or rebalance N/P ratio when there is an inherent imbalance.

In an embodiment, an MTCMOS device is configured to be part of a digital circuit. The MTCMOS device comprises at least one pair of transistors. A first transistor in the pair comprises a first polarity and a first VT flavor. A second transistor in the pair comprises a second polarity and a second VT flavor. The second VT flavor is distinct from the first VT flavor.

In an embodiment, a method of manufacturing an MTCMOS device comprises providing a first channel region between a first source electrode and a first drain electrode in a first area corresponding to a first field-effect transistor (FET) device of a first polarity. The method comprises providing a second channel region between a second source electrode and a second drain electrode in a second area corresponding to a second FET device of a second polarity. The method comprises selectively depositing a first gate stack for the first FET device by depositing a first organic planarization layer on the second channel region of the second FET device, depositing a first high-k (HK) insulating layer in the first area and the second area, depositing a first doped gate metal layer in the first area and the second area, and utilizing lift-off to etch the first organic planarization layer, the first HK insulating layer, and the first doped gate metal layer in the second area. The method comprises selectively depositing a second gate stack for the second FET device by depositing a second organic planarization layer on the first FET device, depositing a second HK insulating layer in the first area and the second area, depositing a second doped gate metal layer in the first area and the second area, and utilizing lift-off to etch the second organic planarization layer, the second HK insulating layer, and the second doped gate metal layer in the first area. The first FET device comprises a first VT flavor and the second FET device comprises a second VT flavor. The second VT flavor is distinct from the first VT flavor.

### BRIEF DESCRIPTION OF THE DRAWING

In the following section, the aspects of the subject matter disclosed herein will be described with reference to exemplary embodiments illustrated in the figures, in which:
FIG. 1 is a block diagram illustrating an MTCMOS one cell-height device, according to an embodiment;
FIG. 2 is circuit diagram illustrating an MTCMOS 2-input NOR gate, according to an embodiment;
FIG. 3 is circuit diagram illustrating an MTCMOS OR2 gate, according to an embodiment;
FIG. 4 is a block diagram illustrating an MTCMOS multi-height standard cell, according to an embodiment;
FIG. 5 is a flowchart illustrating a method of manufacturing an MTCMOS device, according to an embodiment;
FIG. 6 is a flowchart illustrating a method of depositing a first gate stack for a first FET device, according to an embodiment;
FIG. 7 is a flowchart illustrating a method of depositing a second gate stack for a second FET device, according to an embodiment; and
FIG. 8 is a block diagram of an electronic device in a network environment, according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "multi-VT," "high-K," "lift-off," etc.) may be occasionally interchangeably used with a corresponding non-hyphenated version (e.g., "multi VT," "high K," "lift off," etc.), and a capitalized entry (e.g., "Voltage Threshold") may be interchangeably used with a corresponding non-capitalized version (e.g., "voltage threshold"). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

"Threshold Voltage (VT)" as used herein refers to a gate voltage required to induce a channel. For example, an n-channel device may require a positive gate voltage larger than a value VT before a conducting channel is induced. For example, a p-channel device may require a gate voltage more negative than a value VT to induce a required positive charge in the channel.

"VT flavor" as used herein refers to a label given to N-channel metal-oxide-semiconductor (NMOS) and P-channel metal-oxide-semiconductor (PMOS) transistor VTs. Examples of VT flavor include, but are not limited to, regular VT (RVT), mixed VT (MVT), low VT (LVT), very low VT (VLVT), super low VT (SLVT), and ultra-low VT (ULVT).

Disclosed devices and methods may provide an MTCMOS device. The device may be configured to be part of a digital circuit. The device may be configured as a logic integrated circuit. The device may comprise at least one pair of transistors. A first transistor in the pair may comprise a first polarity and a first VT flavor. A second transistor in the pair may comprise a second polarity and a second VT flavor. The second VT flavor may be distinct from the first VT flavor.

In an embodiment, an MTCMOS device may comprise a standard cell. The standard cell may be formed by the first and second transistors.

In an embodiment, an MTCMOS device may comprise a plurality of pairs of transistors. Transistors in the plurality of pairs comprising a first polarity may comprise a first VT flavor. Transistors in the plurality of pairs comprising a second polarity may comprise a second VT flavor.

In an embodiment, a first transistor of an MTCMOS device may comprise a first width. A second transistor of the MTCMOS device may comprise a second width. The second width may be distinct from the first width.

In an embodiment, a first transistor of an MTCMOS device may comprise a first channel length. A second transistor of the MTCMOS device may comprise a second channel length. The second channel length may be distinct from the first channel length.

In an embodiment, each transistor in a pair of transistors in an MTCMOS device may comprise a nanosheet width in a range of minimum manufacturable width to maximum manufacturable width. In other words, there may be no limitations on nanosheet width.

In an embodiment, a digital circuit may comprise a multi-stage circuit.

In an embodiment, a rise delay of a first transistor in a pair of transistors in an MTCMOS device may not be matched to a fall delay of a second transistor in the pair of transistors. A fall delay of the first transistor may not be matched to a rise delay of the second transistor. For example, a lower PMOS VT may result in a faster rise time. For example, a lower NMOS VT may result in a faster fall time.

In an embodiment, a higher NMOS VT flavor and a lower PMOS VT flavor may be utilized to balance rise/fall delays.

Disclosed devices and methods may provide an MTCMOS device. The device may comprise two or more first transistors being part of a merged nanosheet. The merged nanosheet may comprise a first polarity and a first VT flavor. Two or more second transistors may comprise a second polarity. At least one of the second transistors may comprise a second VT flavor distinct from the first VT flavor. One of the second transistors may comprise the first VT flavor.

In an embodiment, an MTCMOS device may comprise a multi-height standard cell. The multi-height standard cell may comprise a standard-height cell. The multi-height standard cell may comprise a 1.5 height cell. The multi-height standard cell may comprise a double height cell. The MTCMOS device may comprise a cell having any height.

In an embodiment, an MTCMOS device may comprise a standard cell. The standard cell may comprise a height being a non-integer multiple of a single-height cell.

In an embodiment, a merged nanosheet may comprise a width in a range of minimum manufacturable width to maximum manufacturable width. In other words, there may be no limitations on width for the merged nanosheet.

Embodiments consistent with the present disclosure may utilize thin gate oxide for logic. Embodiments consistent with the present disclosure may utilize thick gate oxide for logic.

Embodiments consistent with the present disclosure may include a method of manufacturing an MTCMOS device. The method may comprise providing a first channel region between a first source electrode and a first drain electrode in a first area corresponding to a first FET device of a first polarity. The method may comprise providing a second channel region between a second source electrode and a second drain electrode in a second area corresponding to a second FET device of a second polarity. The method may comprise selectively depositing a first gate stack for the first FET device. Selectively depositing a first gate stack for the first FET device may include depositing a first organic planarization layer on the second channel region of the second FET device. Selectively depositing a first gate stack for the first FET device may include depositing a first high-k (HK) insulating layer in the first area and the second area. Selectively depositing a first gate stack for the first FET device may include depositing a first doped gate metal layer in the first area and the second area. Selectively depositing a first gate stack for the first FET device may include utilizing lift-off to etch the first organic planarization layer. Selectively depositing a first gate stack for the first FET device may include utilizing lift-off to etch the first HK insulating layer. Selectively depositing a first gate stack for the first FET device may include utilizing lift-off to etch the first doped gate metal layer in the second area. The method may comprise selectively depositing a second gate stack for the second FET device. Selectively depositing a second gate stack for the second FET device may include depositing a second organic planarization layer on the first FET device. Selectively depositing a second gate stack for the second FET device may include depositing a second HK insulating layer in the first area and the second area. Selectively depositing a second gate stack for the second FET device may include depositing a second doped gate metal layer in the first area and the second area. Selectively depositing a second gate stack for the second FET device may include utilizing lift-off to etch the second organic planarization layer. Selectively depositing a second gate stack for the second FET device may include utilizing lift-off to etch the second HK insulating layer. Selectively depositing a second gate stack for the second FET device may include utilizing lift-off to etch the second doped gate metal layer in the first area. The first FET device may comprise a first VT flavor and the second FET device may comprise a second VT flavor. The second VT flavor may be distinct from the first VT flavor.

In an embodiment, a method may comprise selectively depositing a first gate stack for a first FET device. Selectively depositing a first gate stack for a first FET device may include depositing a first ultrathin dielectric dipole layer in a first area and in a second area. The method may comprise utilizing lift-off to etch the first ultrathin dielectric dipole layer. The method may comprise selectively depositing a second gate stack for a second FET device. Selectively depositing a second gate stack for a second FET device may include depositing a second ultrathin dielectric dipole layer in the first area and the second area. The method may comprise utilizing lift-off to etch the second ultrathin dielectric dipole layer.

In an embodiment, a method may comprise selectively depositing a first gate stack for a first FET device. Selectively depositing a first gate stack for a first FET device may include depositing two or more first ultrathin dielectric dipole layers in a first area and in a second area. The method may comprise utilizing lift-off to etch the first ultrathin dielectric dipole layers. The method may comprise selectively depositing a second gate stack for a second FET device. Selectively depositing a second gate stack for a second FET device may include depositing two or more second ultrathin dielectric dipole layers in the first area and the second area. The method may comprise utilizing lift-off to etch the second ultrathin dielectric dipole layers.

In an embodiment, a method may comprise using one or more of the following to modulate VT: doping, length, work function metal (WFM), dipole, and/or any other process technology.

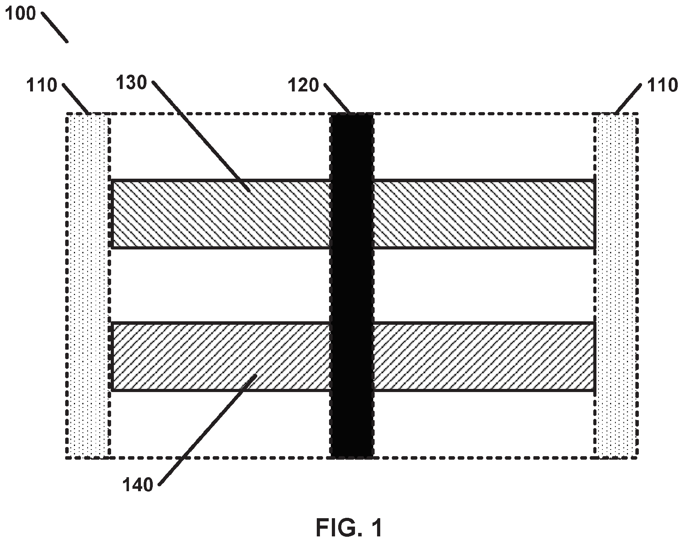

FIG. 1 is a block diagram illustrating an MTCMOS one cell-height device 100, according to an embodiment.

Referring to FIG. 1, the MTCMOS one cell-height device 100 may comprise a single diffusion break (SDB) 110. The MTCMOS one cell-height device 100 may comprise a polysilicon gate 120. The MTCMOS one cell-height device 100 may comprise a first FET 130. The first FET 130 may comprise a first polarity and a first VT flavor. The MTCMOS one cell-height device 100 may comprise a second FET 140. The second FET 140 may comprise a second polarity and a second VT flavor. The second polarity may be distinct from the first polarity. The second VT flavor may be distinct from the first VT flavor.

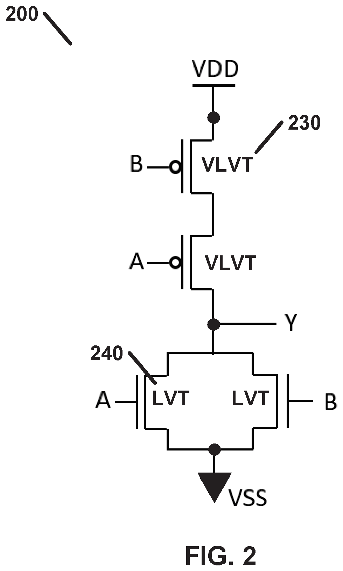

FIG. 2 is circuit diagram illustrating an MTCMOS 2-input NOR gate 200, according to an embodiment.

Referring to FIG. 2, the MTCMOS 2-input NOR gate 200 may comprise a first FET 230 having a first polarity and a first VT flavor. In this example, the first VT flavor may comprise VLVT. The MTCMOS 2-input NOR gate 200 may comprise a second FET 240 having a second polarity and a second VT flavor. In this example, the second VT flavor may comprise LVT. Compared to a 2-input NOR gate comprising only VLVT, the MTCMOS 2-input NOR gate 200 may be configured to balance rise/fall timing and/or improve iso-leakage frequency.

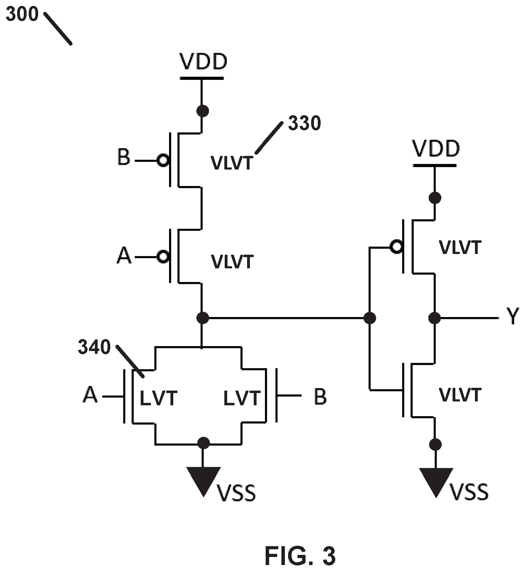

FIG. 3 is circuit diagram illustrating an MTCMOS OR2 gate 300, according to an embodiment.

Referring to FIG. 3, the MTCMOS OR2 gate 300 may comprise a first FET 330 having a first polarity and a first VT flavor. In this example, the first VT flavor may comprise VLVT. The MTCMOS OR2 gate 300 may comprise a second FET 340 having a second polarity and a second VT flavor. In this example, the second VT flavor may comprise LVT. The mixed-VT of the NOR2 gate of the first stage may be used to optimize the iso-leakage frequency of that stage. The mixed-VT of the NOR2 gate of the first stage may be used to optimize the iso-leakage frequency of the combined two stages.

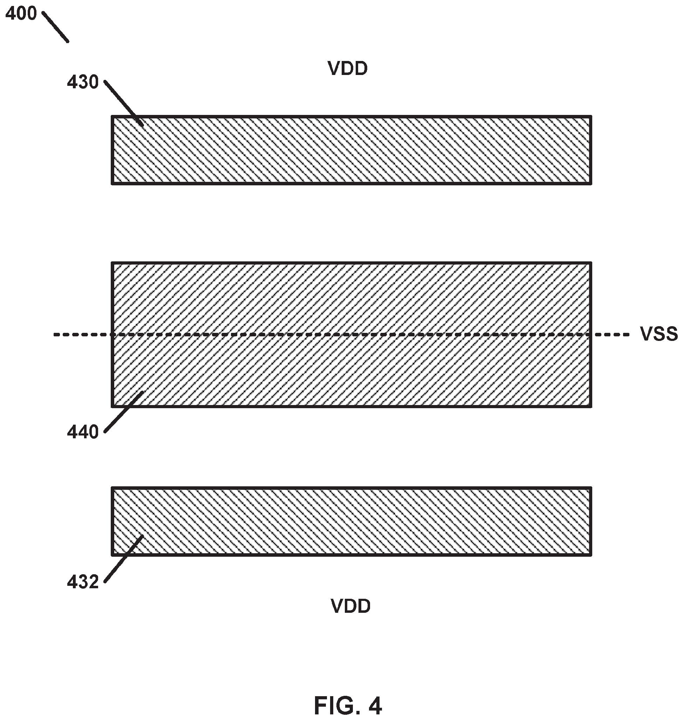

FIG. 4 is a block diagram illustrating an MTCMOS multi-height standard cell 400, according to an embodiment.

Referring to FIG. 4, the MTCMOS multi-height standard cell 400 may comprise a first region 430. The first region 430 may comprise any height. In this example, the first region 430 comprises a standard height. The first region 430 may comprise a first polarity. The first region 430 may comprise a first VT flavor. The MTCMOS multi-height standard cell 400 may comprise a second region 440. The second region 440 may comprise a merged nanosheet. Two or more first transistors may be formed in the merged nanosheet having the first polarity and the first VT flavor. The second region 440 may comprise any height. In this example, the second region 440 comprises a height greater than a standard height. For example, the second region 440 may comprise a 1.5 height cell, a double height cell, or a height greater than a double height cell. The second region 440 may comprise a second polarity. Two or more second transistors having the second polarity may be formed in the MTCMOS multi-height standard cell 400. The second polarity may be distinct from the first polarity. The second region 440 may comprise a second VT flavor. The second VT flavor may be distinct from the first VT flavor. The MTCMOS multi-height standard cell 400 may comprise a third region 432. The third region 432 may comprise any height. In this example, the third region 432 comprises a standard height. The third region 432 may comprise the first polarity. The third region 432 may comprise the first VT flavor, the second VT flavor, or a third VT flavor.

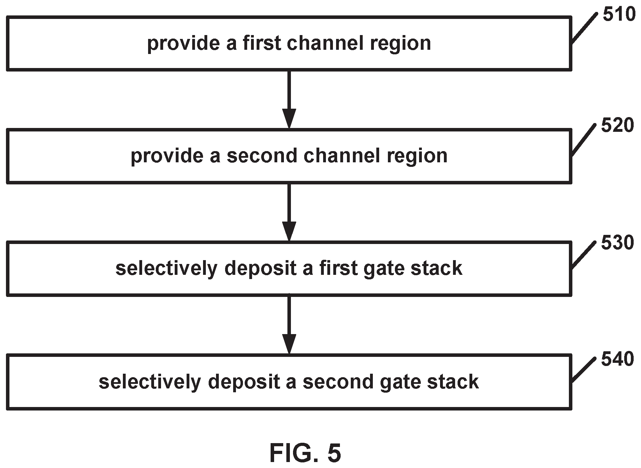

FIG. 5 is a flowchart illustrating a method of manufacturing an MTCMOS device, according to an embodiment.

Referring to FIG. 5, a first channel region may be provided at 510. The first channel region may be provided between a first source electrode and a first drain electrode in a first area corresponding to a first FET device. The first FET device may comprise a first polarity. A second channel region may be provided at 520. The second channel region may be provided between a second source electrode and a second drain electrode in a second area corresponding to a second FET device. The second FET device may comprise a second polarity. The second polarity may be distinct from the first polarity. A first gate stack may be selectively deposited for the first FET device at 530. Selectively depositing the first gate stack may include depositing a first organic planarization layer on the second channel region of the second FET device. Selectively depositing the first gate stack may include depositing a first HK insulating layer in the first area and in the second area. Selectively depositing the first gate stack may include depositing a first doped gate metal layer in the first area and in the second area. Selectively depositing the first gate stack may include utilizing lift-off to etch the first organic planarization layer. Selectively depositing the first gate stack may include utilizing lift-off to etch the first HK insulating layer. Selectively depositing the first gate stack may include utilizing lift-off to etch the first doped gate metal layer in the second area.

A second gate stack may be selectively deposited for the second FET device at 540. Selectively depositing the second gate stack may include depositing a second organic planarization layer on the first FET device. Selectively depositing the second gate stack may include depositing a second HK insulating layer in the first area and in the second area. Selectively depositing the second gate stack may include depositing a second doped gate metal layer in the first area and in the second area. Selectively depositing the second gate stack may include utilizing lift-off to etch the second organic planarization layer. Selectively depositing the second gate stack may include utilizing lift-off to etch the second HK insulating layer. Selectively depositing the second gate stack may include utilizing lift-off to etch the second doped gate metal layer in the first area. The VT flavor of the first FET device may be distinct from the VT flavor of the second FET device. The VT of the first FET device may be substantially distinct from the VT of the second FET device. For example, the difference between the VT of the first FET device and the VT of the second FET device may be greater than 10 mV.

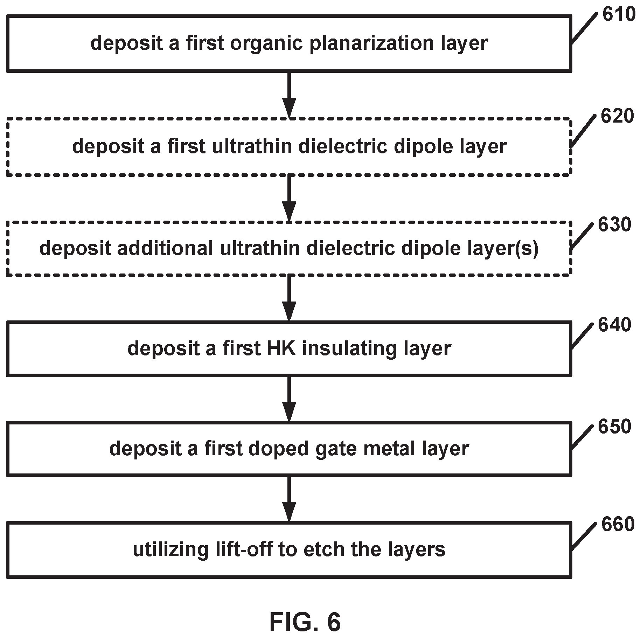

FIG. 6 is a flowchart illustrating a method of depositing a first gate stack for a first FET device, according to an embodiment.

Referring to FIG. 6, a first organic planarization layer may be deposited at 610. A first ultrathin dielectric dipole layer may be deposited at 620. The first ultrathin dielectric dipole layer may be deposited in a first area and in a second area. One or more additional first ultrathin dielectric dipole layers may be deposited at 630. The one or more additional first ultrathin dielectric dipole layers may be deposited in the first area and in the second area. A first HK insulating layer may be deposited at 640. A first doped gate metal layer may be deposited at 650. Lift off may be utilized to etch the layers at 660. Lift off may be utilized to etch the first organic planarization layer. Lift off may be utilized to etch the first ultrathin dielectric dipole layer. Lift off may be utilized to etch the one or more additional first ultrathin dielectric dipole layers. Lift off may be utilized to etch the first HK insulating layer. Lift off may be utilized to etch the first doped gate metal layer.

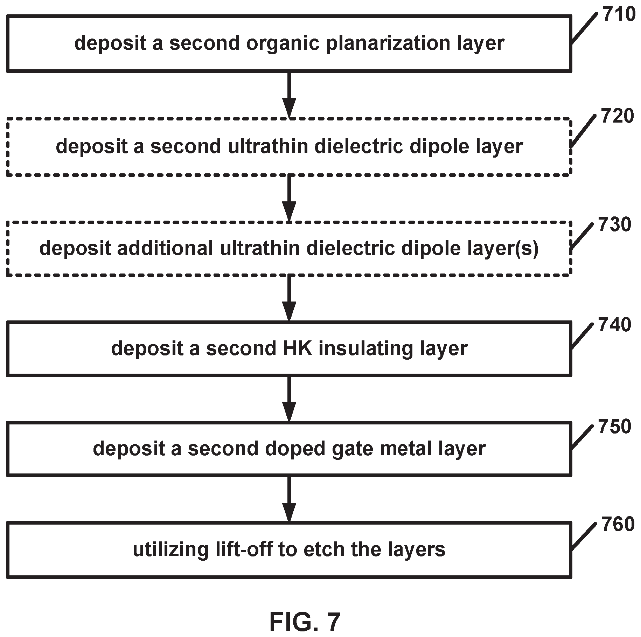

FIG. 7 is a flowchart illustrating a method of depositing a second gate stack for a second FET device, according to an embodiment.

Referring to FIG. 7, a second organic planarization layer may be deposited at 710. A second ultrathin dielectric dipole layer may be deposited at 720. The second ultrathin dielectric dipole layer may be deposited in a first area and in a second area. One or more additional second ultrathin dielectric dipole layers may be deposited at 730. The one or more additional second ultrathin dielectric dipole layers may be deposited in the first area and in the second area. A second HK insulating layer may be deposited at 740. A second doped gate metal layer may be deposited at 750. Lift off may be utilized to etch the layers at 760. Lift off may be utilized to etch the second organic planarization layer. Lift off may be utilized to etch the second ultrathin dielectric dipole layer. Lift off may be utilized to etch the one or more additional second ultrathin dielectric dipole layers. Lift off may be utilized to etch the second HK insulating layer. Lift off may be utilized to etch the second doped gate metal layer.

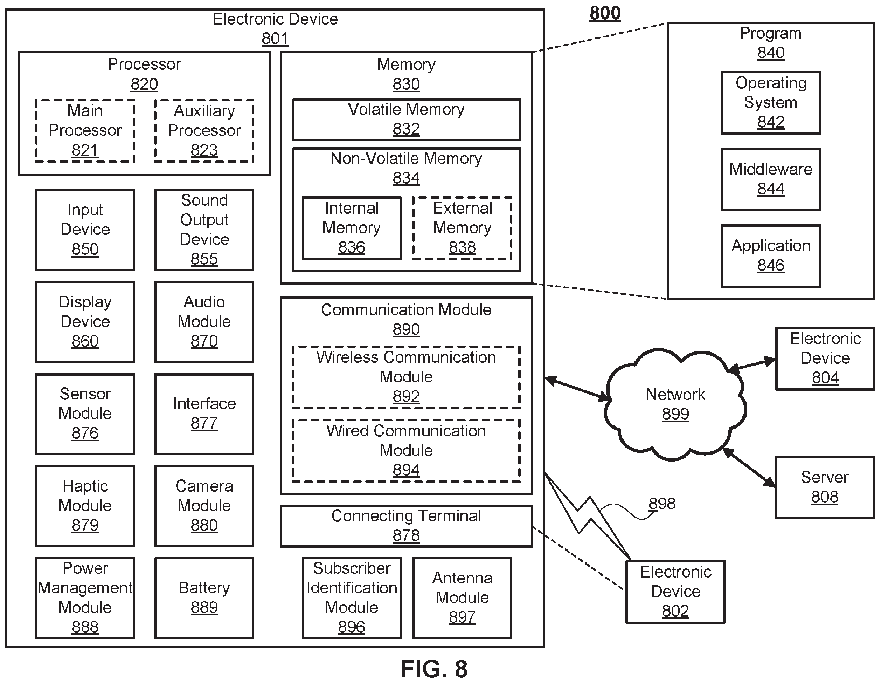

FIG. 8 is a block diagram of an electronic device in a network environment 800, according to an embodiment. For example, an electronic device may comprise an MTCMOS device.

Referring to FIG. 8, an electronic device 801 in a network environment 800 may communicate with an electronic device 802 via a first network 898 (e.g., a short-range wireless communication network), or an electronic device 804 or a server 808 via a second network 899 (e.g., a long-range wireless communication network). The electronic device 801 may communicate with the electronic device 804 via the server 808. The electronic device 801 may include a processor 820, a memory 830, an input device 850, a sound output device 855, a display device 860, an audio module 870, a sensor module 876, an interface 877, a haptic module 879, a camera module 880, a power management module 888, a battery 889, a communication module 890, a subscriber identification module (SIM) card 896, or an antenna module 897. In one embodiment, at least one (e.g., the display device 860 or the camera module 880) of the components may be omitted from the electronic device 801, or one or more other components may be added to the electronic device 801. Some of the components may be implemented as a single integrated circuit (IC). For example, the sensor module 876 (e.g., a fingerprint sensor, an iris sensor, or an illuminance sensor) may be embedded in the display device 860 (e.g., a display).

The processor 820 may execute software (e.g., a program 840) to control at least one other component (e.g., a hardware or a software component) of the electronic device 801 coupled with the processor 820 and may perform various data processing or computations.

As at least part of the data processing or computations, the processor 820 may load a command or data received from another component (e.g., the sensor module 876 or the communication module 890) in volatile memory 832, process the command or the data stored in the volatile memory 832, and store resulting data in non-volatile memory 834. The processor 820 may include a main processor 821 (e.g., a central processing unit (CPU) or an application processor (AP)), and an auxiliary processor 823 (e.g., a graphics processing unit (GPU), an image signal processor (ISP), a sensor hub processor, or a communication processor (CP)) that is operable independently from, or in conjunction with, the main processor 821. Additionally or alternatively, the auxiliary processor 823 may be adapted to consume less power than the main processor 821, or execute a particular function. The auxiliary processor 823 may be implemented as being separate from, or a part of, the main processor 821.

The auxiliary processor 823 may control at least some of the functions or states related to at least one component (e.g., the display device 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). The auxiliary processor 823 (e.g., an image signal processor or a communication processor) may be implemented as part of another component (e.g., the camera module 880 or the communication module 890) functionally related to the auxiliary processor 823.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834. Non-volatile memory 834 may include internal memory 836 and/or external memory 838.

The program 840 may be stored in the memory 830 as software, and may include, for example, an operating system (OS) 842, middleware 844, or an application 846.

The input device 850 may receive a command or data to be used by another component (e.g., the processor 820) of the electronic device 801, from the outside (e.g., a user) of the electronic device 801. The input device 850 may include, for example, a microphone, a mouse, or a keyboard.

The sound output device 855 may output sound signals to the outside of the electronic device 801. The sound output device 855 may include, for example, a speaker or a receiver. The speaker may be used for general purposes, such as playing multimedia or recording, and the receiver may be used for receiving an incoming call. The receiver may be implemented as being separate from, or a part of, the speaker.

The display device 860 may visually provide information to the outside (e.g., a user) of the electronic device 801. The display device 860 may include, for example, a display, a hologram device, or a projector and control circuitry to control a corresponding one of the display, hologram device, and projector. The display device 860 may include touch circuitry adapted to detect a touch, or sensor circuitry (e.g., a pressure sensor) adapted to measure the intensity of force incurred by the touch.

The audio module 870 may convert a sound into an electrical signal and vice versa. The audio module 870 may obtain the sound via the input device 850 or output the sound via the sound output device 855 or a headphone of an external electronic device 802 directly (e.g., wired) or wirelessly coupled with the electronic device 801.

The sensor module 876 may detect an operational state (e.g., power or temperature) of the electronic device 801 or an environmental state (e.g., a state of a user) external to the electronic device 801, and then generate an electrical signal or data value corresponding to the detected state. The sensor module 876 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device 802 directly (e.g., wired) or wirelessly. The interface 877 may include, for example, a high- definition multimedia interface (HDMI), a universal serial bus (USB) interface, a secure digital (SD) card interface, or an audio interface.

A connecting terminal 878 may include a connector via which the electronic device 801 may be physically connected with the external electronic device 802. The connecting terminal 878 may include, for example, an HDMI connector, a USB connector, an SD card connector, or an audio connector (e.g., a headphone connector).

The haptic module 879 may convert an electrical signal into a mechanical stimulus (e.g., a vibration or a movement) or an electrical stimulus which may be recognized by a user via tactile sensation or kinesthetic sensation. The haptic module 879 may include, for example, a motor, a piezoelectric element, or an electrical stimulator.

The camera module 880 may capture a still image or moving images. The camera module 880 may include one or more lenses, image sensors, image signal processors, or flashes. The power management module 888 may manage power supplied to the electronic device 801. The power management module 888 may be implemented as at least part of, for example, a power management integrated circuit (PMIC).

The battery 889 may supply power to at least one component of the electronic device 801. The battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the AP) and supports a direct (e.g., wired) communication or a wireless communication. The communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device via the first network 898 (e.g., a short-range communication network, such as BLUETOOTH^{™}, wireless-fidelity (Wi-Fi) direct, or a standard of the Infrared Data Association (IrDA)) or the second network 899 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 892 may identify and authenticate the electronic device 801 in a communication network, such as the first network 898 or the second network 899, using subscriber information (e.g., international mobile subscriber identity (IMSI)) stored in the subscriber identification module 896.

The antenna module 897 may transmit or receive a signal or power to or from the outside (e.g., the external electronic device) of the electronic device 801. The antenna module 897 may include one or more antennas, and, therefrom, at least one antenna appropriate for a communication scheme used in the communication network, such as the first network 898 or the second network 899, may be selected, for example, by the communication module 890 (e.g., the wireless communication module 892). The signal or the power may then be transmitted or received between the communication module 890 and the external electronic device via the selected at least one antenna.

Commands or data may be transmitted or received between the electronic device 801 and the external electronic device 804 via the server 808 coupled with the second network 899. Each of the electronic devices 802 and 804 may be a device of a same type as, or a different type, from the electronic device 801. All or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 801. The electronic device 801 may provide the outcome, with or without further processing of the outcome, as at least part of a reply to the request. To that end, a cloud computing, distributed computing, or client-server computing technology may be used, for example.

Embodiments of the subject matter and the operations described in this specification may be implemented in digital electronic circuitry, or in computer software, silicon processes and/or devices, firmware, or hardware, including the structures disclosed in this specification and their structural equivalents, or in combinations of one or more of them.

Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A multi-threshold voltage, VT, complementary metal-oxide-semiconductor, MTCMOS, device being configured as part of a digital circuit, the MTCMOS device comprising:
at least one pair of transistors,
wherein a first transistor (130) in the at least one pair has a first polarity and a first VT flavor, and
wherein a second transistor (140) in the at least one pair has a second polarity and a second VT flavor distinct from the first VT flavor.

2. The device of claim 1, further comprising a standard cell.

3. The device of claim 2, wherein the transistors in a plurality of pairs having the first polarity have the first VT flavor; and
wherein the transistors in the plurality of pairs having the second polarity have the second VT flavor.

4. The device of any one of claims 1 to 3, wherein the first transistor (130) comprises a first width, and the second transistor (140) comprises a second width distinct from the first width.

5. The device of any one of claims 1 to 4, wherein the first transistor (130) comprises a first channel length, and the second transistor (140) comprises a second channel length distinct from the first channel length.

6. The device of any one of claims 1 to 5, wherein each of the transistors comprises a nanosheet width in a range of minimum manufacturable width to maximum manufacturable width.

7. The device of any one of claims 1 to 6, wherein the digital circuit comprises a multi-stage circuit.

8. The device of any one of claims 1 to 7, wherein a rise delay of the first transistor (130) is not matched to a fall delay of the second transistor (140).

9. The device of any one of claims 1 to 8, wherein a fall delay of the first transistor (130) is not matched to a rise delay of the second transistor (140).

10. The multi-threshold voltage, VT, complementary metal-oxide-semiconductor, MTCMOS, device of claim 1, comprising:
two or more first transistors being a merged nanosheet (having the first polarity and the first VT flavor; and
two or more second transistors having the second polarity, at least one of the second transistors having the second VT flavor distinct from the first VT flavor.

11. The device of claim 10, further comprising a multi-height standard cell.

12. The device of claim 10, further comprising a standard cell having a height being a non-integer multiple of a single-height cell.

13. The device of any one of claims 10 to 12, wherein the merged nanosheet comprises a width in a range of minimum manufacturable width to maximum manufacturable width.

14. A method of manufacturing a multi-threshold voltage, VT, complementary metal-oxide-semiconductor, MTCMOS, device, the method comprising:
providing (510) a first channel region between a first source electrode and a first drain electrode in a first area corresponding to a first field-effect transistor, FET, device of a first polarity;
providing (520) a second channel region between a second source electrode and a second drain electrode in a second area corresponding to a second FET device of a second polarity;
selectively depositing (530) a first gate stack for the first FET device by:
depositing (610) a first organic planarization layer on the second channel region of the second FET device;
depositing (640) a first high-k, HK, insulating layer in the first area and the second area;
depositing (650) a first doped gate metal layer in the first area and the second area; and
utilizing (660) lift-off to etch the first organic planarization layer, the first HK insulating layer, and the first doped gate metal layer in the second area; and
selectively depositing (540) a second gate stack for the second FET device by:
depositing (710) a second organic planarization layer on the first FET device;
depositing (740) a second HK insulating layer in the first area and the second area;
depositing (750) a second doped gate metal layer in the first area and the second area; and
utilizing (760) lift-off to etch the second organic planarization layer, the second HK insulating layer, and the second doped gate metal layer in the first area, the first FET device having a first VT flavor and the second FET device having a second VT flavor distinct from the first VT flavor.

15. The method of claim 14, wherein:
selectively depositing (530) the first gate stack for the first FET device includes depositing (620) a first ultrathin dielectric dipole layer in the first area and the second area;
utilizing lift-off to etch includes utilizing lift-off to etch the first ultrathin dielectric dipole layer;
selectively depositing the second gate stack for the second FET device includes depositing (630) a second ultrathin dielectric dipole layer in the first area and the second area; and
utilizing lift-off to etch includes utilizing lift-off to etch the second ultrathin dielectric dipole layer.
